# EUROPÄISCHE PATENTSCHRIFT

(11) **EP 1 153 394 B1**
(45) Veröffentlichungstag und Bekanntmachung des Hinweises auf die Patenterteilung: **06.11.2002**
(21) Anmeldenummer: 00908965.7
(22) Anmeldetag: 01.02.2000
(51) Int. Cl.: G11C 11/402, G11C 11/404

(54) **VERFAHREN ZUM BETRIEB EINER SPEICHERZELLENANORDNUNG MIT SELBSTVERSTÄRKENDEN DYNAMISCHEN SPEICHERZELLEN**
METHOD FOR OPERATING A MEMORY CELL ARRAY WITH SELF-AMPLIFYING DYNAMIC MEMORY CELLS
PROCEDE POUR FAIRE FONCTIONNER UN ENSEMBLE DE CELLULES MEMOIRES COMPORTANT DES CELLULES MEMOIRES DYNAMIQUES A AUTO-AMPLIFICATION

(30) Priorität: 22.02.1999 DE 19907540
(43) Veröffentlichungstag der Anmeldung: 14.11.2001
(73) Patentinhaber: Infineon Technologies AG, 81669 München (DE)
(72) Erfinder: KRAUTSCHNEIDER, Wolfgang, D-21149 Hamburg (DE); SCHLÖSSER, Till, D-81825 München (DE); HOFMANN, Franz, D-80995 München (DE); WILLER, Josef, D-85521 Riemerling (DE)
(74) Vertreter: Kottmann, Heinz Dieter, Dipl.-Ing.
(86) Internationale Anmeldenummer: DE0000282
(87) Internationale Veröffentlichungsnummer: WO00051133

(56) Entgegenhaltungen:
- US-A- 3 786 437
- US-A- 5 463 234
- US-A- 5 581 106

## Beschreibung

Die Erfindung betrifft ein Verfahren zum Betrieb einer Speicherzellenanordnung mit selbstverstärkenden dynamischen Speicherzellen.

Als eine Speicherzelle einer Speicherzellenanordnung wird derzeit meist eine sogenannte Ein-Transistor-Speicherzelle eingesetzt. Eine solche Speicherzelle umfaßt einen Transistor und einen Kondensator, auf dem die Information in Form einer Ladung gespeichert ist. Durch Ansteuerung des Transistors über eine Wortleitung kann die Ladung auf dem Kondensator über eine Bitleitung ausgelesen werden. Da die Ladung des Kondensators die Bitleitung treibt und ein durch die Ladung erzeugtes Signal trotz Hintergrundrauschen erkennbar bleiben soll, muß der Kondensator eine Mindestkapazität aufweisen. Diese Anforderung an den Kondensator stellt ein Hindernis bei der Erhöhung der Packungsdichte der Speicherzellenanordnung dar, da der Kondensator nicht beliebig verkleinert werden kann.

Dieses Problem wird in einer alternativen Speicherzellenanordnung, in der als Speicherzellen sogenannte Gainzellen, d.h. selbstverstärkende dynamische Speicherzellen, eingesetzt werden, umgangen. Auch hier ist die Information in Form einer elektrischen Ladung gespeichert. Die elektrische Ladung muß jedoch nicht direkt eine Bitleitung treiben, sondern wird auf einer Gateelektrode eines Speichertransistors gespeichert und dient nur zu dessen Steuerung, wozu schon eine sehr kleine Menge an elektrischer Ladung ausreicht.

In der Europäischen Patentschrift EP 537203 wird eine Speicherzellenanordnung beschrieben, bei der eine Speicherzelle eine selbstverstärkende dynamische Speicherzelle ist, die einen Auswahltransistor, einen Speichertransistor und einen Schottkyübergang umfaßt. Eine Gateelektrode des Auswahltransistors ist mit einer Wortleitung verbunden. Der Auswahltransistor und der Speichertransistor sind in Reihe und zwischen eine Bitleitung und einen Spannungsanschluß, an dem eine Betriebsspannung anliegt, geschaltet. Der Schottkyübergang ist zwischen die Gateelektrode des Speichertransistors und ein Source/Drain-Gebiet des Auswahltransistors geschaltet. Zum Schreiben von Information auf eine Speicherzelle wird der zugehörige Auswahltransistor über die zugehörige Wortleitung angesteuert. Die Bitleitung wird abhängig von der Art der Information mit einer niedrigen Spannung U_{BL} oder mit einer hohen Spannung U_{BH} beaufschlagt. Die Ladung auf der Gateelektrode des Speichertransistors, die sich dabei einstellt, ist abhängig von der Spannung an der Bitleitung und stellt die Information dar. Zum Auslesen der Information wird der Auswahltransistor über die Wortleitung angesteuert und die Bitleitung wird mit der niedrigen Spannung U_{BL} beaufschlagt. Wurde die Gateelektrode des Speichertransistors zuvor durch die hohe Spannung UBH an der Bitleitung aufgeladen, so entsteht ein Spannungsunterschied zwischen der Gateelektrode und einem Source/Drain-Gebiet des Speichertransistors, der größer ist als eine Schwellspannung des Speichertransistors, so daß eine Signalladung durch einen Strom zwischen dem Spannungsanschluß und der Bitleitung, hervorgerufen wird. Wurde die Gateelektrode des Speichertransistors durch die niedrige Spannung U_{BL} an der Bitleitung aufgeladen, so entsteht kein Spannungsunterschied zwischen der Gateelektrode und dem Source/Drain-Gebiet des Speichertransistors, der größer als die Schwellspannung des Speichertransistors ist, so daß kein Strom fließt.

In M. Heshami et al "A 250-MHz Skewed-Clock Pipelined Data Buffer" IEEE Journal of Solid-State Circuits, Vol. 31, No. 3 (1996) 376, wird eine Speicherzellenanordnung beschrieben, bei der eine Speicherzelle eine selbstverstärkende dynamische Speicherzelle ist, die einen ersten Auswahltransistor, einen Speichertransistor und einen zweiten Auswahltransistor umfaßt. Der erste Auswahltransistor ist zwischen eine erste Bitleitung und eine Gateelektrode des Speichertransistors geschaltet. Eine Gateelektrode des ersten Auswahltransistors ist mit einer ersten Wortleitung verbunden. Der zweite Auswahltransistor ist zwischen ein Source/Drain-Gebiet des Speichertransistors und eine zweite Bitleitung geschaltet. Eine Gateelektrode des zweiten Auswahltransistors ist mit einer zweiten Wortleitung verbunden. Ein weiteres Source/Drain-Gebiet des Speichertransistors ist mit einem Spannungsanschluß verbunden. Zum Schreiben einer Information auf die Gateelektrode des Speichertransistors wird der erste Auswahltransistor über die erste Wortleitung angesteuert, so daß sich an der Gateelektrode des Speichertransistors eine Spannung einstellt, die abhängig ist von einer Spannung an der ersten Bitleitung, dessen Größe wiederum von der zu schreibenden Information abhängt. Zum Auslesen der Information wird der zweite Auswahltransistor über die zweite Wortleitung angesteuert. Je nach Information, d. h. je nach Spannung auf der Gateelektrode des Speichertransistors, ist der Speichertransistor leitend oder gesperrt, und es fließt ein Strom zwischen dem Spannungsanschluß und der zweiten Bitleitung oder nicht.

Aus US-A-5 463 234 ist eine Speicherzellenanordnung mit selbstverstärkenden dynamischen Speicherzellen bekannt. Gemäß dieser Entgegenhaltung liegt die Auslesespannung zwischen O und V_{DD}-Vth.

Der Erfindung liegt das Problem zugrunde, ein Verfahren zum Betrieb einer Speicherzellenanordnung mit selbstverstärkenden dynamischen Speicherzellen anzugeben, bei dem bei gegebener Betriebsspannung eine Signalladung größer ist als im Vergleich zum Stand der Technik.

Das Problem wird gelöst durch ein Verfahren zum Betrieb einer Speicherzellenanordnung mit selbstverstärkenden dynamischen Speicherzellen, bei dem die Speicherzellen jeweils mindestens einen Speichertransistor umfassen. Zum Schreiben einer ersten Information auf eine der Speicherzellen wird eine Gateelektrode des zugehörigen Speichertransistors so aufgeladen, daß an ihr eine erste Spannung anliegt. Zum Schreiben einer zweiten Information auf die Speicherzelle wird die Gateelektrode des Speichertransistors so aufgeladen, daß an ihr eine zweite Spannung anliegt. Jeweils zum Auslesen der ersten Information und zum Auslesen der zweiten Information wird an ein erstes Source/Drain-Gebiet des Speichertransistors eine Betriebsspannung angelegt und an ein zweites Source/Drain-Gebiet des Speichertransistors eine Auslesespannung angelegt. Die erste Spannung liegt zwischen der zweiten Spannung und der Auslesespannung. Die Auslesespannung liegt zwischen der ersten Spannung abzüglich einer Schwellspannung des Speichertransistors und der zweiten Spannung abzüglich der Schwellspannung des Speichertransistors.

Die selbstverstärkende dynamische Speicherzelle umfaßt den Speichertransistor, auf dessen Gateelektrode die Information in Form einer Ladung gespeichert ist. Die Ladung wird beim Schreiben so eingestellt, daß bei der ersten Information der Speichertransistor gesperrt ist, d.h., daß kein Strom durch den Speichertransistor fließen kann, während er bei der zweiten Information leitend ist. Beim Auslesen der zweiten Information fließt im Gegensatz zum Auslesen der ersten Information eine Signalladung durch den Speichertransistor. Die Signalladung fließt zwischen dem ersten Source/Drain-Gebiet und dem zweiten Source/Drain-Gebiet des Speichertransistors. Da die Auslesespannung nicht gleich der ersten Spannung ist und nicht zwischen der ersten Spannung und der zweiten Spannung liegt, ist ein Spannungsunterschied zwischen der Gateelektrode des Speichertransistors und dem zweiten Source/Drain-Gebiet des Speichertransistors größer als wenn die Auslesespannung gleich der ersten Spannung wäre. Ein elektrischer Widerstand des Speichertransistors ist also kleiner, so daß durch ihn eine besonders große Signalladung fließen kann. Im Vergleich zum Stand der Technik, bei dem die erste Spannung gleich der Auslesespannung ist, kann bei derselben Betriebsspannung eine größere Signalladung fließen. Im Vergleich zum Stand der Technik, bei dem die erste Spannung gleich der Auslesespannung ist, kann dieselbe Signalladung bei kleinerer Betriebsspannung fließen. Allgemein formuliert, ist die Betriebsspannung geteilt durch die Signalladung kleiner als im Vergleich zum Stand der Technik. Bei gegebener Betriebsspannung ist eine Signalladung größer als im Vergleich zum Stand der Technik. Die Auslesespannung liegt zwischen der ersten Spannung abzüglich der Schwellspannung des Speichertransistors und der zweiten Spannung abzüglich der Schwellspannung des Speichertransistors, damit der Speichertransistor beim Auslesen der ersten Information gesperrt ist und beim Auslesen der zweiten Information leitend ist. Dem liegt die Tatsache zugrunde, daß ein Transistor dann leitend ist, wenn ein Spannungsunterschied zwischen seiner Gateelektrode und mindestens einem Source/Drain-Gebiet größer als der Betrag seiner Schwellspannung ist. Die Betriebsspannung wird so gewählt, daß der Speichertransistor gesperrt ist, wenn an seiner Gateelektrode die erste Spannung anliegt. Andernfalls wäre der Speichertransistor unabhängig von der Größe der Auslesespannung leitend.

Handelt es sich beispielsweise beim Speichertransistor um einen n-Kanal-Transistor, bei dem das erste und das zweite Source/Drain-Gebiet n-dotiert sind, so ist die zweite Spannung größer als die erste Spannung und die erste Spannung größer als die Auslesespannung. Die Auslesespannung ist größer als die erste Spannung abzüglich der Schwellspannung des Speichertransistors und kleiner als die zweite Spannung abzüglich der Schwellspannung des Speichertransistors. Die Schwellspannung ist größer als die erste Spannung abzüglich der Betriebsspannung. Die Schwellspannung ist vorzugsweise größer als die zweite Spannung abzüglich der Betriebsspannung. In diesem Fall kann an dem ersten Source/Drain-Gebiet des Speichertransistors auch dann die Betriebsspannung anliegen, wenn am zweiten Source/Drain-Gebiet des Speichertransistors nicht die Äuslesespannung anliegt, ohne daß deshalb der Speichertransistor leitend ist.

Das Analoge gilt für eine Speicherzellenanordnung, bei der der Speichertransistor ein p-Kanal-Transistor ist, so daß das erste Source/Drain-Gebiet und das zweite Source/Drain-Gebiet des Speichertransistors p-dotiert sind. Es müssen lediglich die Vorzeichen der Spannungen verändert werden. Die zweite Spannung beispielsweise ist also kleiner als die erste Spannung, und die erste Spannung ist kleiner als die Auslesespannung.

Im folgenden bedeutet "Spannung x ist fast gleich y", daß x möglichst so nahe bei y liegt, daß eine jeweils bekannte Bedingung gerade noch erfüllt wird.

Die Auslesespannung ist vorzugsweise fast gleich der ersten Spannung abzüglich der Schwellspannung des Speichertransistors, d.h. gerade noch so groß, daß beim Auslesen kein Strom durch den Speichertransistor fließt, wenn an seiner Gateelektrode die erste Spannung anliegt. Die Summe aus der Auslesespannung und der Schwellspannung ist also näherungsweise 0 Volt. Unter der Bedingung, daß beim Auslesen der ersten Information der Speichertransistor gesperrt ist, ist der Spannungsunterschied zwischen der zweiten Spannung und der Auslesespannung in diesem Fall maximal, so daß der Speichertransistor maximal viel Strom durchläßt. Die Signalladung ist besonders groß.

Die erste Spannung beträgt beispielsweise 0 V. In diesem Fall beträgt die Auslesespannung vorzugsweise fast die negative Schwellspannung des Speichertransistors. Für den Fall, daß der Speichertransistor ein n-Kanal-Transistor ist, ist die Auslesespannung etwas größer als die negative Schwellspannung. Beträgt die Schwellspannung beispielsweise 1 Volt, so beträgt die Auslesespannung z.B. -0.8 Volt.

Die Speicherzelle kann mindestens einen Aüswahltransistor umfassen, dessen erstes Source/Drain-Gebiet mit einer Bitleitung, dessen zweites Source/Drain-Gebiet mit der Gateelektrode des Speichertransistors und dessen Gateelektrode mit einer Wortleitung verbunden ist. Zum Schreiben der ersten Information wird die Wortleitung so angesteuert, daß die Gateelektrode des Speichertransistors mit der Bitleitung elektrisch verbunden wird. An der Bitleitung wird eine solche erste Bitleitungsspannung angelegt, daß an der Gateelektrode des Speichertransistors die erste Spannung anliegt. Zum Schreiben der zweiten Information auf die Speicherzelle wird die Wortleitung so angesteuert, daß die Gateelektrode des Speichertransistors mit der Bitleitung elektrisch verbunden wird. An der Bitleitung wird eine solche zweite Bitleitungsspannung angelegt, daß an der Gateelektrode des Speichertransistors die zweite Spannung anliegt.

Die zweite Bitleitungsspannung kann gleich der Betriebsspannung sein.

Der Einfachheit halber wird im folgenden auf einen Speichertransistor Bezug genommen, der ein n-Kanal-Transistor ist. Das Analoge gilt jedoch für den Fall, daß der Speichertransistor ein p-Kanal-Transistor ist. Es sind lediglich die Vorzeichen der Spannungen zu verändern.

Der Auswahltransistor ist vorzugsweise ebenfalls ein n-Kanal-Transistor, wenn der Speichertransistor ein n-Kanal-Transistor ist.

In einem ersten Fall kann die Wortleitung beim Schreiben der zweiten Information angesteuert werden, indem sie mit einer Spannung beaufschlagt wird, die gleich der Summe aus der Betriebsspannung und einer Schwellspannung des Auswahltransistors ist. Der Auswahltransistor bleibt solange leitend wie ein Spannungsunterschied zwischen seiner Gateelektrode und dem ersten Source/Drain-Gebiet oder dem zweiten Source/Drain-Gebiet größer als seine Schwellspannung ist. Da an der Gateelektrode des Auswahltransistors die Summe aus der Betriebsspannung und der Schwellspannung anliegt und an der Bitleitung der Betriebsspannung anliegt, kann solange ein Strom fließen, bis an der Gateelektrode des Speichertransistors ebenfalls die Betriebsspannung anliegt. Die zweite Spannung ist folglich in diesem ersten Fall gleich der Betriebsspannung.

In einem zweiten Fall kann die Wortleitung beim Schreiben der zweiten Information angesteuert werden, indem sie mit der Betriebsspannung beaufschlagt wird. In diesem Fall fließt durch den Auswahltransistor beim Schreiben der zweiten Information nur solange Strom, bis an der Gateelektrode des Speichertransistors die Betriebsspannung abzüglich der Schwellspannung des Auswahltransistors anliegt. Die Ladung auf der Gateelektrode des Speichertransistors ist geringer als im ersten Fall. Da beim Auslesen der zweiten Information der Spannungsunterschied zwischen der Gateelektrode und dem zweiten Source/Drain-Gebiet des Speichertransistors geringer ist als im ersten Fall, fließt weniger Strom durch den Speichertransistor als im ersten Fall. Die Signalladung ist damit kleiner.

Zur Vereinfachung des Verfahrens ist es vorteilhaft, die Wortleitung beim Schreiben der ersten Information mit derselben Spannung zu beaufschlagen wie beim Schreiben der zweiten Information. Beim zweiten Fall ist dann beim Schreiben der ersten Information ein Spannungsunterschied zwischen der Gateelektrode des Auswahltransistors und seinem ersten Source/Drain-Gebiet kleiner als im ersten Fall, so daß ein Gatedielektrikum des Auswahltransistors dünner sein kann. Die kleine Dicke des Gatedielektrikums ist vorteilhaft, da sie zu einer hohen Steilheit und zu einer hohen Performance des Auswahltransistors führt. Leistungskenndaten des Auswahltransistors können aufgrund der kleinen Dicke des Gatedielektrikums so gut sein, daß sie die Anforderungen für Transistor einer Logikschaltung erfüllen. Sowohl die Transistoren der Speicherzellenanordnung als auch die Transistoren der Logikschaltung können folglich gleichzeitig auf einem Chip erzeugt werden.

Der Wert der Spannung an der Wortleitung kann an die jeweiligen Erfordernisse angepaßt werden. Je größer die Signalladung sein soll, um so höher wird die Spannung gewählt. Vorzugsweise ist die Spannung nicht größer als im oben beschriebenen ersten Fall, da die zweite Spannung an der Gateelektrode des Speichertransistors die zweite Bitleitungsspannung nicht übersteigen kann. Je dünner das Gatedielektrikum sein soll, um so kleiner wird die Spannung gewählt. Es liegt im Rahmen der Erfindung, einen Kompromiß einzugehen, so daß die Spannung an der Wortleitung zwischen der Betriebsspannung und der Summe aus der Betriebsspannung und der Schwellspannung liegt.

Zur Verkleinerung des Prozeßaufwands bei der Herstellung der Speicherzellenanordnung ist es vorteilhaft, wenn der Auswahltransistor und der Speichertransistor gleichzeitig erzeugt werden, so daß ihre Gatedielektrika dieselben Dicken aufweisen. Der Auswahltransistor und der Speichertransistor können dieselbe Schwellspannung aufweisen.

Die Speicherzelle kann mindestens eine Diode umfassen, die zwischen das zweite Source/Drain-Gebiet des Auswahltransistors und die Gateelektrode des Speichertransistors so geschaltet ist, daß ein Abfließen von Ladung von der Gateelektrode des Speichertransistors zum zweiten Source/Drain-Gebiet des Auswahltransistors erschwert wird. Die Sperrichtung der Diode zeigt also von der Gateelektrode des Speichertransistors zum zweiten Source/Drain-Gebiet des Auswahltransistors. Das zweite Source/Drain-Gebiet des Auswahltransistors ist mit dem zweiten Source/Drain-Gebiet des Speichertransistors verbunden. Jeweils zum Auslesen der ersten Information und zum Auslesen der zweiten Information wird die Wortleitung angesteuert, so daß der Auswahltransistor als Auslesetransistor wirkt. Pro Speicherzelle ist also nur eine Bitleitung und eine Wortleitung vorgesehen. Bei der Wahl der Dicke des Gatedielektrikums des Auswahltransistors muß nicht nur die Differenz aus der Spannung an der Wortleitung und der ersten Bitleitungsspannung berücksichtigt werden, sondern auch die Differenz aus der Spannung an der Wortleitung und der Auslesespannung.

Im folgenden ist der Begriff "Auslesetransistor" mit dem Begriff "Auswahltransistor" austauschbar für den Fall einer Speicherzelle mit Diode.

Die Speicherzellenanordnung kann besonders einfach aufgebaut sein, wenn die Wortleitung sowohl beim Schreiben als auch beim Auslesen mit derselben Spannung beaufschlagt wird.

Im oben beschriebenen ersten Fall ist dann der maximale Spannungsunterschied zwischen der Gateelektrode und dem ersten Source/Drain-Gebiet des Auswahltransistors gleich der Summe aus der Betriebsspannung und der Schwellspannung abzüglich der Auslesespannung. Dieser Spannungsunterschied ist also fast gleich der Summe aus der Betriebsspannung und der zweifachen Schwellspannung. Im oben beschriebenen zweiten Fall ist der maximale Spannungsunterschied zwischen der Gateelektrode und dem ersten Source/Drain-Gebiet des Auswahltransistors gleich der Betriebsspannung abzüglich der Auslesespannung. Der Spannungsunterschied ist also fast gleich der Summe aus der Betriebsspannung und der Schwellspannung des Speichertransistors.

Die Speicherzelle kann eine Drei-Transistor-Speicherzelle sein, wie sie z.B. in M. Heshami et al (s.o.) beschrieben wird. Beispielsweise umfaßt die Speicherzelle einen Auslesetransistor, dessen erstes Source/Drain-Gebiet mit dem zweiten Source/Drain-Gebiet des Speichertransistors verbunden ist. Jeweils zum Auslesen der ersten Information und zum Auslesen der zweiten Information wird eine Gateelektrode des Auslesetransistors angesteuert. Die Gateelektrode des Auslesetransistors ist beispielsweise mit einer weiteren Wortleitung verbunden. Ein zweites Source/Drain-Gebiet des Auslesetransistors kann mit einer weiteren Bitleitung verbunden sein, über die die Signalladung bestimmt wird. Die Wortleitung und die weitere Wortleitung können identisch sein. In diesem Fall sind die Bitleitung und die weitere Bitleitung voneinander verschieden. Die Bitleitung und die weitere Bitleitung können identisch sein. In diesem Fall sind die Wortleitung und die weitere Wortleitung voneinander verschieden.

Umfaßt die Speicherzelle die Diode, kann das Gatedielektrikum des Auswahltransistors besonders dünn sein, wenn die Wortleitung beim Auslesen mit einer kleineren Spannung beaufschlagt wird als beim Schreiben. Vorzugsweise wird die Spannung an der Wortleitung an die Auslesespannung so angepaßt, daß ein Spannungsabfall am Gatedielektrikum des Auswahltransistors sowohl beim Schreiben als auch beim Auslesen derselbe ist. Im oben beschriebenen ersten Fall ist dann die Spannung an der Wortleitung beim Auslesen gleich der Summe aus der Betriebsspannung, der Schwellspannung und der Auslesespannung, so daß der maximale Spannungsunterschied zwischen der Gateelektrode und dem ersten Source/Drain-Gebiet des Auswahltransistors, der beim Betrieb der Speicherzellenanordnung am Gatedielektrikum des Auswahltransistors abfällt, gleich der Summe aus der Betriebsspannung und der Schwellspannung ist. Die Spannung an der Wortleitung beim Auslesen ist z.B. fast gleich der Betriebsspannung. Im oben beschriebenen zweiten Fall ist dann die Spannung an der Wortleitung beim Auslesen gleich der Summe aus der Betriebsspannung und der Auslesespannung, so daß der maximale Spannungsunterschied zwischen der Gateelektrode und dem ersten Source/Drain-Gebiet des Auswahltransistors, der beim Betrieb der Speicherzellenanordnung am Gatedielektrikum des Auswahltransistors abfällt, gleich der Betriebsspannung ist. Die Spannung an der Wortleitung beim Auslesen ist z.B. fast gleich der Betriebsspannung abzüglich der Schwellspannung des Auslesetransistors.

Damit zwischen dem ersten Source/Drain-Gebiet des Auslesetransistors und einem Substrat, in dem das erste Source/Drain-Gebiet des Auslesetransistors angeordnet ist, beim Anliegen der Auslesespannung kein erhöhter Leckstrom entsteht, ist es vorteilhaft, wenn am Substrat eine Spannung anliegt, die nicht größer als die Auslesespannung ist. P-n-Übergänge zwischen Source/Drain-Gebieten der Transistoren und dem Substrat sind dann in Sperrrichtung gepolt.

Das erste Source/Drain-Gebiet des Speichertransistors kann mit einem Spannungsanschluß verbunden sein, der konstant auf der Betriebsspannung gehalten wird.

Im folgenden werden Ausführungsbeispiele der Erfindung anhand der Figuren näher erläutert.
- Figur 1: zeigt ein Schaltbild einer Speicherzelle beim Schreiben einer ersten Information gemäß eines ersten Ausführungsbeispiels.
- Figur 2: zeigt das Schaltbild der Speicherzelle beim Auslesen der ersten Information gemäß des ersten Ausführungsbeispiels.
- Figur 3: zeigt das Schaltbild der Speicherzelle beim Schreiben einer zweiten Information gemäß des ersten Ausführungsbeispiels.
- Figur 4: zeigt das Schaltbild der Speicherzelle beim Auslesen der zweiten Information gemäß des ersten Ausführungsbeispiels.
- Figur 5: zeigt das Schaltbild der Speicherzelle beim Auslesen einer Information einer anderen Speicherzelle gemäß des ersten Ausführungsbeispiels.
- Figur 6: zeigt das Schaltbild einer Speicherzelle beim Schreiben einer ersten Information gemäß eines zweiten Ausführungsbeispiels.
- Figur 7: zeigt das Schaltbild der Speicherzelle beim Schreiben einer zweiten Information gemäß des zweiten Ausführungsbeispiels.
- Figur 8: zeigt das Schaltbild der Speicherzelle beim Auslesen der ersten Information gemäß des zweiten Ausführungsbeispiels.
- Figur 9: zeigt das Schaltbild der Speicherzelle beim Auslesen der zweiten Information gemäß dem zweiten Ausführungsbeispiel.
- Figur 10: zeigt das Schaltbild der Speicherzelle beim Auslesen einer Information einer anderen Speicherzelle gemäß des zweiten Ausführungsbeispiels.

Die Ausführungsbeispiele gehen von einer Speicherzellenanordnung mit selbstverstärkenden dynamischen Speicherzellen aus, bei der die Speicherzellen jeweils einen Speichertransistor S, einen Auswahltransistor A und eine Diode D umfassen. Der Auswahltransistor A und der Speichertransistor S sind in Reihe und zwischen einen Spannungsanschluß Q und eine Bitleitung B geschaltet. Ein erstes Source/Drain-Gebiet des Speichertransistors S ist mit dem Spannungsanschluß Q verbunden. Ein erstes Source/Drain-Gebiet des Auswahltransistors A ist mit der Bitleitung B verbunden. Ein zweites Source/Drain-Gebiet des Auswahltransistors A ist mit einer Gateelektrode des Speichertransistors S und mit einem zweiten Source/Drain-Gebiet des Speichertransistors S verbunden. Zwischen das zweite Source/Drain-Gebiet des Auswahltransistors A und die Gateelektrode des Speichertransistors S ist die Diode D so geschaltet, daß ein Abfließen von Ladung von der Gateelektrode des Speichertransistors S zum zweiten Source/Drain-Gebiet des Auswahltransistors A erschwert wird. Der Spannungsanschluß wird konstant auf einer Betriebsspannung V_{DD}, die 2 V beträgt, gehalten. Die Source/Drain-Gebiete des Auswahltransistors A und des Speichertransistors S sind n-dotiert, d. h., es handelt sich beim Auswahltransistor A und beim Speichertransistor S um n-Kanal-Transistoren. Eine Schwellspannung V_{T} des Auswahltransistors A und eine Schwellspannung V_{T} des Speichertransistors S betragen ca. 1V. Die Source/Drain-Gebiete des Auswahltransistors A und des Speichertransistors S sind in einem Substrat angeordnet, an dem eine Spannung von -1V anliegt.

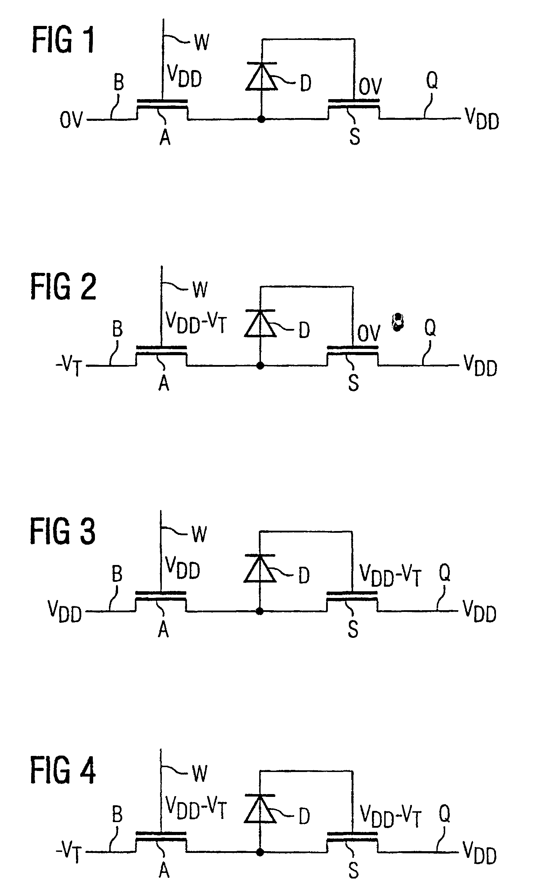

In einem ersten Ausführungsbeispiel wird zum Schreiben einer ersten Information, die dem logischen Wert 0 entspricht, die Wortleitung W mit der Betriebsspannung V_{DD} beaufschlagt, so daß der Auswahltransistor A leitend ist. An die Bitleitung B wird eine erste Bitleitungsspannung angelegt, die 0 V beträgt, so daß sich an der Gateelektrode des Speichertransistors S eine erste Spannung einstellt, die auch 0 V beträgt. Da die erste Spannung kleiner ist als die Schwellspannung V_{T}, ist der Speichertransistor S gesperrt. Zwischen dem Spannungsanschluß Q und der Bitleitung B fließt kein Strom (siehe Figur 1).

Zum Auslesen der ersten Information wird die Wortleitung W mit einer Spannung beaufschlagt, die gleich der Betriebsspannung V_{DD} abzüglich einer Schwellspannung V_{T} ist, so daß der Auswahltransistor A leitend ist. Die Bitleitung B wird mit einer Auslesespannung beaufschlagt, die gleich der negativen Schwellspannung V_{T} des Auswahltransistors A ist. Die Diode D ist in Sperrrichtung gepolt, so daß nur eine sehr geringfügige Ladung von der Gateelektrode des Speichertransistors S zur Bitleitung B fließt. Die Auslesespannung ist zwar kleiner als die erste Spannung an der Gateelektrode des Speichertransistors S, doch ihre Differenz beträgt weniger als die Schwellspannung V_{T}, so daß der Speichertransistor gesperrt ist und kein Strom vom Spannungsanschluß Q zur Bitleitung B fließt. Ein Spannungsunterschied zwischen der Gateelektrode des Auswahltransistors A und den Source/Drain-Gebieten des Auswahltransistors A beträgt nie mehr als die Betriebsspannung V_{DD} (siehe Figur 2).

Zum Schreiben einer zweiten Information, die dem logischen Wert 1 entspricht, wird die Wortleitung W mit der Betriebsspannung V_{DD} beaufschlagt, so daß der Auswahltransistor A leitend ist. Die Bitleitung B wird mit der Betriebsspannung V_{DD} beaufschlagt, so daß sich auf der Gateelektrode des Speichertransistors S eine zweite Spannung einstellt, die gleich der Betriebsspannung V_{DD} abzüglich der Schwellspannung V_{T} ist. Die zweite Spannung ist nicht gleich der Betriebsspannung V_{DD}, da der Auswahltransistor A nur so lange leitend ist, wie ein Spannungsunterschied zwischen der Gateelektrode des Auswahltransistors A und eines seiner Source/Drain-Gebiete größer als die Schwellspannung V_{T} ist. (siehe Figur 3).

Zum Auslesen der zweiten Information wird die Wortleitung W mit einer Spannung beaufschlagt, die gleich der Betriebsspannung V_{DD} abzüglich der Schwellspannung V_{T} ist. An die Bitleitung B wird die Auslesespannung angelegt. Die Diode D ist in Sperrrichtung gepolt, so daß Ladung von der Gateelektrode des Speichertransistors S zur Bitleitung B nur langsam abfließt. Da die Auslesespannung kleiner ist als die zweite Spannung und ihre Differenz, d.h. der Spannungsunterschied zwischen der Gateelektrode des Speichertransistors S und der Bitleitung B größer als die Schwellspannung V_{T} ist, nämlich gleich der Betriebsspannung V_{DD} ist, ist der Speichertransistor S leitend und es fließt ein Strom vom Spannungsanschluß Q zur Bitleitung B (siehe Figur 4). An der resultierenden Signalladung wird erkannt, daß es sich um die zweite Information handelt. Ein Spannungsunterschied zwischen der Gateelektrode des Speichertransistors S und seinen Source/Drain-Gebieten beträgt nie mehr als die Betriebsspannung V_{DD}.

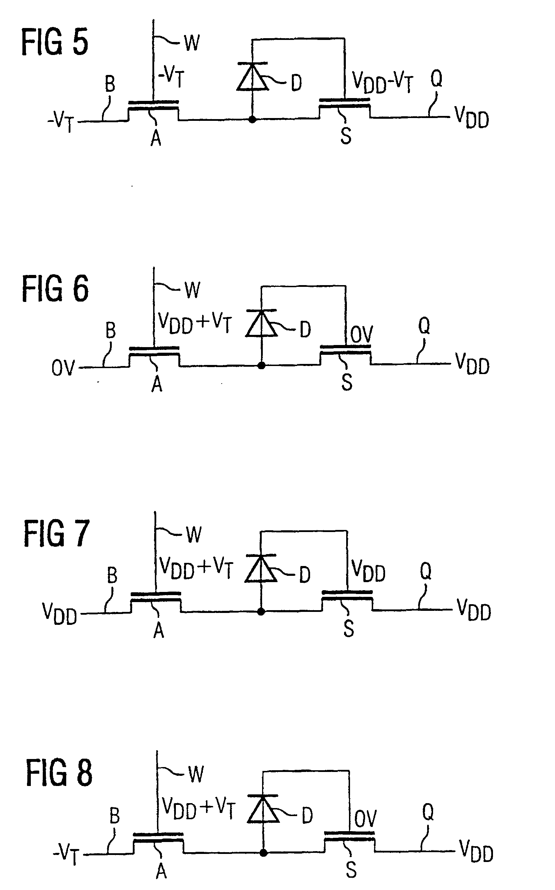

Beim Auslesen einer Information einer anderen Speicherzelle, an deren Bitleitung die Auslesespannung anliegt, wird die Wortleitung W mit einer Spannung beaufschlagt, die vorzugsweise gleich der negativen Schwellspannung V_{T} des Speichertransistors S ist. Ein Spannungsunterschied zwischen dem ersten Source/Drain-Gebiet des Auslesetransistors A und seiner Gateelektrode ist in diesem Fall minimal, so daß Leckströme durch den Auslesetransistor ebenfalls minimal sind. Ist in der Speicherzelle die zweite Information gespeichert, so beträgt ein Spannungsunterschied zwischen der Gateelektrode des Auswahltransistors A und dem zweiten Source/Drain-Gebiet des Auswahltransistors A die Betriebsspannung V_{DD} (siehe Figur 5.)

Außerhalb Zeiten, zu denen Information auf die Speicherzelle geschrieben wird oder Information von der Speicherzelle ausgelesen wird, liegen an der Wortleitung W die negative Schwellspannung V_{T} und an der Bitleitung B 0V an.

Da der Spannungsunterschied zwischen der Gateelektrode des Auswahltransistors A und seinen Source/Drain-Gebieten und ein Spannungsunterschied zwischen der Gateelektrode des Speichertransistors S und seinen Source/Drain-Gebieten nie größer als die Betriebsspannung V_{DD} ist, können Gatedielektrika des Auswahltransistors A und des Speichertransistors S eine geringe Dicke aufweisen. Im Ausführungsbeispiel betragen die Dicken der Gatedielektrika ca. 4 nm und bestehen aus SiO₂.

Auf dem Substrat, auf dem die Speicherzellenanordnung angeordnet ist, ist auch eine Logikschaltung angeordnet. Da die Gatedielektrika des Auswahltransistors A und des Speichertransistors S dünn sind, können Transistoren der Logikschaltung gleichzeitig mit der Speicherzellenanordnung erzeugt werden, und die Transistoren der Logikschaltung weisen aufgrund der geringen Dicke ihrer Gatedielektrika eine hohe Steilheit und eine hohe Performance auf.

In einem zweiten Ausführungsbeispiel wird zum Schreiben der ersten Information und der zweiten Information die Wortleitung W mit einer Spannung beaufschlagt, die gleich der Summe aus der Betriebsspannung V_{DD} und der Schwellspannung V_{T} ist. Beim Schreiben der ersten Information wird die Bitleitung B mit der Spannung 0 V beaufschlagt. Die Spannungsdifferenz zwischen der Gateelektrode des Auswahltransistors und seinem ersten Source/Drain-Gebiet beträgt V_{DD} + V_{T} (siehe Figur 6).

Zum Schreiben der zweiten Information wird die Bitleitung mit der Betriebsspannung V_{DD} beaufschlagt, so daß sich an der Gateelektrode des Speichertransistors S die Betriebsspannung V_{DD} einstellt (siehe Figur 7). Die zweite Spannung ist in diesem Ausführungsbeispiel also größer als im ersten Ausführungsbeispiel.

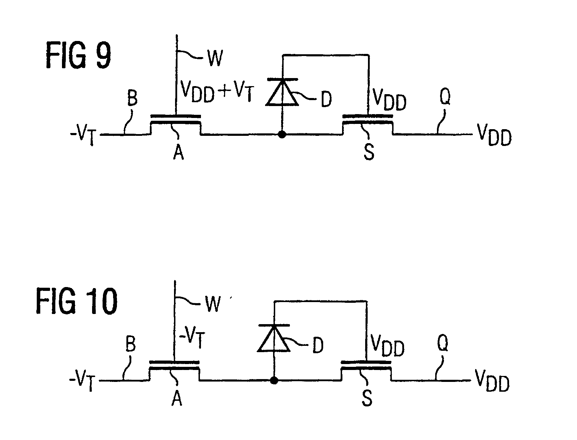

Wie beim Schreiben wird auch beim Auslesen der ersten Information bzw. der zweiten Information an der Wortleitung W die Spannung V_{DD} + V_{T} angelegt (siehe Figur 8 und Figur 9). An die Bitleitung B wird eine Auslesespannung angelegt, die der Auslesespannung aus dem ersten Ausführungsbeispiel entspricht. Die Auslesespannung beträgt also fast - V_{T}. Im Gegensatz zum ersten Ausführungsbeispiel beträgt der Spannungsunterschied zwischen der Gateelektrode des Speichertransistors S und der Bitleitung B beim Auslesen der zweiten Information V_{DD} + V_{T} (siehe Figur 9). Der elektrische Widerstand Speichertransistor S ist also kleiner als beim ersten Ausführungsbeispiel, so daß mehr Strom vom Spannungsanschluß Q zur Bitleitung B fließt, und die Signalladung folglich größer ist.

Beim Auslesen der ersten Information oder der zweiten Information beträgt ein Spannungsunterschied zwischen der Gateelektrode des Auswahltransistors A und der Bitleitung B V_{DD} + 2 V_{T}. Aufgrund dieses großen Spannungsunterschieds ist das Gatedielektrikum des Auswahltransistors A dicker als beim ersten Ausführungsbeispiel und beträgt ca. 8nm. Auch beim Speichertransistor S ist beim Auslesen der zweiten Information der Spannungsunterschied zwischen der Gateelektrode und der Bitleitung B mit V_{DD} + V_{T} größer als beim ersten Ausführungsbeispiel, so daß das Gatedielektrikum des Speichertransistors S dicker sein sollte als beim ersten Ausführungsbeispiel. Damit die Speicherzellenanordnung mit geringem Prozeßaufwand hergestellt werden kann, ist die Dicke des Gatedielektrikums des Speichertransistors S gleich der Dicke des Gatedielektrikums des Auswahltransistors A.

Ein Auslesen einer Information einer anderen Speicherzelle wird entsprechend dem ersten Ausführungsbeispiel durchgeführt (siehe Figur 10).

Außerhalb Zeiten, zu denen Information auf die Speicherzelle geschrieben wird oder Information von der Speicherzelle ausgelesen wird, liegen an der Wortleitung W - V_{T} und an der Bitleitung B 0V an.

Es sind viele Variationen der Ausführungsbeispiele denkbar, die ebenfalls im Rahmen der Erfindung liegen. So können die Betriebsspannung und die Schwellspannung an die jeweiligen Erfordernisse angepaßt werden. Zwischen die Diode und die Gateelektrode des Speichertransistors kann ein Kondensator geschaltet sein, um die Kapazität an der Gateelektrode des Speichertransistors zu erhöhen.

Die Speicherzelle kann eine Drei-Transistor-Speicherzelle sein.

## Patentansprüche

1. Verfahren zum Betrieb einer Speicherzellenanordnung mit selbstverstärkenden dynamischen Speicherzellen, bei dem:
- die Speicherzellen jeweils mindestens einen Speichertransistor (S) umfassen,
- zum Schreiben einer ersten Information auf eine der Speicherzellen eine Gateelektrode des zugehörigen Speichertransistors (S) so aufgeladen wird, daß an ihr eine erste Spannung anliegt,
- zum Schreiben einer zweiten Information auf die Speicherzelle die Gateelektrode des Speichertransistors (S) so aufgeladen wird, daß an ihr eine zweite Spannung anliegt, und
- jeweils zum Auslesen der ersten Information und zum Auslesen der zweiten Information an ein erstes Source/Drain-Gebiet des Speichertransistors (S) eine Betriebsspannung (V_{DD}) angelegt wird, und an ein zweites Source/Drain-Gebiet des Speichertransistors (S) eine Auslesespannung angelegt wird,
**dadurch gekennzeichnet, dass**
- die erste Spannung zwischen der zweiten Spannung und der Auslesespannung liegt,
- die Auslesespannung zwischen der ersten Spannung abzüglich einer Schwellspannung (V_{T}) des Speichertransistors (S) und der zweiten Spannung abzüglich der Schwellspannung (V_{T}) des Speichertransistors (S) liegt,
- die Betriebsspannung (V_{DD}) so gewählt wird, daß beim Auslesen der ersten Information der Speichertransistor (S) gesperrt ist.

2. Verfahren nach Anspruch 1,
- bei dem die Summe aus der Auslesespannung und der Schwellspannung näherungsweise 0 Volt beträgt.

3. Verfahren nach Anspruch 1 oder 2,
- bei dem die erste Spannung 0 Volt beträgt.

4. Verfahren nach einem der Ansprüche 1 bis 3,
- bei dem die Speicherzelle mindestens einen Auswahltransistor (A) umfaßt, dessen erstes Source/Drain-Gebiet mit einer Bitleitung (B), dessen zweites Source/Drain-Gebiet mit der Gateelektrode des Speichertransistors (S) und dessen Gateelektrode mit einer Wortleitung (W) verbunden sind,
- bei dem zum Schreiben der ersten Information auf die Speicherzelle die Wortleitung (W) angesteuert wird, so daß eine Gateelektrode des Speichertransistors (S) mit der Bitleitung (B) elektrisch verbunden wird, und an der Bitleitung (B) eine solche erste Bitleitungsspannung angelegt wird, daß an der Gateelektrode des Speichertransistors (S) die erste Spannung anliegt,
- bei dem zum Schreiben der zweiten Information auf die Speicherzelle die Wortleitung (W) angesteuert wird, so daß die Gateelektrode des Speichertransistors (S) mit der Bitleitung (B) elektrisch verbunden wird, und an der Bitleitung (B) eine solche zweite Bitleitungsspannung angelegt wird, daß an der Gateelektrode des Speichertransistors (S) die zweite Spannung anliegt.

5. Verfahren nach Anspruch 4,
- bei dem die zweite Bitleitungsspannung gleich einer Betriebsspannung (V_{DD}) ist,
- bei dem zum Ansteuern der Wortleitung (W) beim Schreiben der ersten Information und beim Schreiben der zweiten Information, die Wortleitung (W) mit einer Spannung beaufschlagt wird, die gleich der Summe aus der Betriebsspannung (V_{DD}) und einer Schwellspannung (V_{T}) des Auswahltransistors (A) ist, so daß die zweite Spannung gleich der Betriebsspannung (V_{DD}) ist.

6. Verfahren nach Anspruch 4,
- bei dem die zweite Bitleitungsspannung gleich einer Betriebsspannung (V_{DD}) ist,
- bei dem zum Ansteuern der Wortleitung (W) beim Schreiben der ersten Information und beim Schreiben der zweiten Information, die Wortleitung (W) mit der Betriebsspannung (V_{DD}) beaufschlagt wird, so daß die zweíte Spannung gleich der Betriebsspannung (V_{DD}) abzüglich einer Schwellspannung (V_{T}) des Auswahltransistors (A) ist.

7. Verfahren nach einem der Ansprüche 4 bis 6,
- bei dem die Speicherzelle mindestens eine Diode (D) umfaßt, die zwischen das zweite Source/Drain-Gebiet des Auswahltransistors (A) und die Gateelektrode des Speichertransistors (S) so geschaltet ist, daß ein Abfließen von Ladung von der Gateelektrode des Speichertransistors (S) zum zweiten Source/Drain-Gebiet des Auswahltransistors (A) erschwert wird,
- bei dem das zweite Source/Drain-Gebiet des Auswahltransistors (A) mit dem zweiten Source/Drain-Gebiet des Speichertransistors (S) verbunden ist,
- bei dem jeweils zum Auslesen der ersten Information und zum Auslesen der zweiten Information die Wortleitung angesteuert wird, so daß der Auswahltransistor (A) als Auslesetransistor wirkt.

8. Verfahren nach einem der Ansprüche 4 bis 6,
- bei dem die Speicherzelle einen Auslesetransistor umfaßt, dessen erstes Source/Drain-Gebiet mit dem zweiten Source/Drain-Gebiet des Speichertransistors (S) verbunden ist,
- bei dem jeweils zum Auslesen der ersten Information und zum Auslesen der zweiten Information eine Gateelektrode des Auslesetransistors angesteuert wird.

9. Verfahren nach Anspruch 7 oder 8,
- bei dem jeweils zum Auslesen der ersten Information und zum Auslesen der zweiten Information die Gateelektrode des Auslesetransistors mit einer Spannung beaufschlagt wird, die gleich der Summe aus der Betriebsspannung (V_{DD}) und der Auslesespannung ist.

10. Verfahren nach einem der Ansprüche 7 bis 9,
- bei dem die Speicherzellenanordnung in einem Substrat angeordnet ist, an dem eine Spannung anliegt, die für den Fall, daß der Auslesetransistor ein n-Kanal-Transistor ist, nicht größer als die Auslesespannung ist und die für den Fall, daß der Auslesetransistor ein p-Kanal-Transistor ist, nicht kleiner als die Auslesespannung ist.

## Claims

1. Method for operating a memory cell arrangement having dynamic gain memory cells, in which:
- the memory cells each comprise at least one memory transistor (S),
- in order to write a first information item to one of the memory cells, a gate electrode of the associated memory transistor (S) is charged in such a way that a first voltage is present on it,
- in order to write a second information item to the memory cell, the gate electrode of the memory transistor (S) is charged in such a way that a second voltage is present on it, and
- in each case in order to read out the first information item and in order to read out the second information item, an operating voltage (V_{DD}) is applied to a first source/drain region of the memory transistor (S), and a read-out voltage is applied to a second source/drain region of the memory transistor (S),
**characterized in that**
- the first voltage lies between the second voltage and the read-out voltage,
- the read-out voltage lies between the first voltage minus a threshold voltage (V_{T}) of the memory transistor (S) and the second voltage minus the threshold voltage (V_{T}) of the memory transistor (S),
- the operating voltage (V_{DD}) is chosen in such a way that the memory transistor (S) is in the off state when the first information item is read out.

2. Method according to Claim 1,
- in which the sum of the read-out voltage and the threshold voltage is approximately 0 volts.

3. Method according to Claim 1 or 2,
- in which the first voltage is 0 volts.

4. Method according to one of Claims 1 to 3,
- in which the memory cell comprises at least one selection transistor (A), whose first source/drain region is connected to a bit line (B), whose second source/drain region is connected to the gate electrode of the memory transistor (S), and whose gate electrode is connected to a word line (W),
- in which, in order to write the first information item to the memory cell, the word line (W) is driven, so that a gate electrode of the memory transistor (S) is electrically connected to the bit line (B), and a first bit line voltage is applied to the bit line (B) such that the first voltage is present on the gate electrode of the memory transistor (S),
- in which, in order to write the second information item to the memory cell, the word line (W) is driven, so that the gate electrode of the memory transistor (S) is electrically connected to the bit line (B), and a second bit line voltage is applied to the bit line (B) such that the second voltage is present on the gate electrode of the memory transistor (S).

5. Method according to Claim 4,
- in which the second bit line voltage is equal to an operating voltage (V_{DD}),
- in which, in order to drive the word line (W) during the writing of the first information item and during the writing of the second information item, the word line (W) has applied to it a voltage which is equal to the sum of the operating voltage (V_{DD}) and a threshold voltage (V_{T}) of the selection transistor (A), so that the second voltage is equal to the operating voltage (V_{DD}).

6. Method according to Claim 4,
- in which the second bit line voltage is equal to an operating voltage (VDD),
- in which, in order to drive the word line (W) during the writing of the first information item and during the writing of the second information item, the word line (W) has applied to it the operating voltage (V_{DD}), so that the second voltage is equal to the operating. voltage (V_{DD}) minus a threshold voltage (V_{T}) of the selection transistor (A).

7. Method according to one of Claims 4 to 6,
- in which the memory cell comprises at least one diode (D) connected between the second source/drain region of the selection transistor (A) and the gate electrode of the memory transistor (S) in such a way that it becomes more difficult for charge to flow away from the gate electrode of the memory transistor (S) to the second source/drain region of the selection transistor (A),
- in which the second source/drain region of the selection transistor (A) is connected to the second source/drain region of the memory transistor (S),
- in which, in each case in order to read out the first information item and in order to read out the second information item, the word line is driven, so that the selection transistor (A) acts as a read-out transistor.

8. Method according to one of Claims 4 to 6,
- in which the memory cell comprises a read-out transistor whose first source/drain region is connected to the second source/drain region of the memory transistor (S),
- in which in each case in order to read out the first information item and in order to read out the second information item, a gate electrode of the read-out transistor is driven.

9. Method according to Claim 7 or 8,
- in which, in each case in order to read out the first information item and in order to read out the second information item, the gate electrode of the read-out transistor has applied to it a voltage which is equal to the sum of the operating voltage (V_{DD}) and the read-out voltage.

10. Method according to one of Claims 7 to 9,
- in which the memory cell arrangement is arranged in a substrate across which there is a voltage which is not greater than the read-out voltage for the case where the read-out transistor is an n-channel transistor, and is not less than the read-out voltage for the case where the read-out transistor is a p-channel transistor.

## Revendications

1. Procédé pour faire fonctionner un ensemble de cellules mémoires comportant des cellules mémoires dynamiques à auto-amplification, dans lequel :
- les cellules mémoires comprennent chacune au moins un transistor de mémorisation (S),
- pour écrire une première information sur l'une des cellules mémoires, on charge une électrode de grille du transistor de mémorisation (S) associé de telle sorte qu'une première tension lui est appliquée,
- pour écrire une deuxième information sur la cellule mémoire, on charge l'électrode de grille du transistor de mémorisation (S) de telle sorte qu'une deuxième tension lui est appliquée, et
- à chaque fois, pour lire la première information et pour lire la deuxième information, on applique à une première zone source-drain du transistor de mémorisation (S) une tension de fonctionnement (V_{DD}) et on applique à une deuxième zone source-drain du transistor de mémorisation (S) une tension de lecture,
**caractérisé par le fait que**
- la première tension est comprise entre la deuxième tension et la tension de lecture,
- la tension de lecture est comprise entre la première tension moins une tension de seuil (V_{T}) du transistor de mémorisation (S) et la deuxième tension moins la tension de seuil (V_{T}) du transistor de mémorisation (S),
- on choisit la tension de fonctionnement (V_{DD}) de telle sorte que, lors de la lecture de la première information, le transistor de mémorisation (S) est bloqué.

2. Procédé selon la revendication 1,
- dans lequel la somme de la tension de lecture et de la tension de seuil vaut approximativement 0 Volt.

3. Procédé selon la revendication 1 ou 2,
- dans lequel la première tension vaut 0 Volt.

4. Procédé selon l'une des revendications 1 à 3,
- dans lequel la cellule mémoire comprend au moins un transistor de sélection (A) dont la première zone source-drain est reliée à une ligne de bit (B), dont la deuxième zone source-drain est reliée à l'électrode de grille du transistor de mémorisation (S) et dont l'électrode de grille est reliée à une ligne de mot (W),
- dans lequel, pour écrire la première information sur la cellule mémoire, on commande la ligne de mot (W) de telle sorte qu'une électrode de grille du transistor de mémorisation (S) est reliée électriquement à la ligne de bit (B) et on applique à la ligne de bit (B) une première tension de ligne de bit telle que la première tension s'applique à l'électrode de grille du transistor de mémorisation (S),
- dans lequel, pour écrire la deuxième information sur la cellule mémoire, on commande la ligne de mot (W) de telle sorte que l'électrode de grille du transistor de mémorisation (S) est reliée électriquement à la ligne de bit (B) et on applique à la ligne de bit (B) une deuxième tension de ligne de bit telle que la deuxième tension s'applique à l'électrode de grille du transistor de mémorisation (S).

5. Procédé selon la revendication 4,
- dans lequel la deuxième tension de ligne de bit est égale à une tension de fonctionnement (V_{DD}).
- dans lequel, pour commander la ligne de mot (W), lors de l'écriture de la première information et lors de l'écriture de la deuxième information, on alimente la ligne de mot (W) avec une tension qui est égale à la somme de la tension de fonctionnement (V_{DD}) et d'une tension de seuil (V_{T}) du transistor de sélection (A) de telle sorte que la deuxième tension est égale à la tension de fonctionnement (V_{DD}).

6. Procédé selon la revendication 4,
- dans lequel la deuxième tension de ligne de bit est égale à une tension de fonctionnement (V_{DD}),
- dans lequel, pour commander la ligne de mot (W), lors de l'écriture de la première information et lors de l'écriture de la deuxième information, on alimente la ligne de mot (W) avec la tension de fonctionnement (VDD) de telle sorte que la deuxième tension est égale à la tension de fonctionnement (V_{DD}) moins une tension de seuil (V_{T}) du transistor de sélection (A).

7. Procédé selon l'une des revendications 4 à 6,
- dans lequel la cellule mémoire comprend au moins une diode (D) qui est branchée entre la deuxième zone source-drain du transistor de sélection (A) et l'électrode de grille du transistor de mémorisation (S) de telle sorte qu'une évacuation de la charge de l'électrode de grille du transistor de mémorisation (S) vers la deuxième zone source-drain du transistor de sélection (A) est rendue plus difficile,
- dans lequel la deuxième zone source-drain du transistor de sélection (A) est reliée à la deuxième zone source-drain du transistor de mémorisation (S),
- dans lequel, à chaque fois, pour lire la première information et pour lire la deuxième information, on commande la ligne de mot de telle sorte que le transistor de sélection (A) agit comme transistor de lecture.

8. Procédé selon l'une des revendications 4 à 6,
- dans lequel la cellule mémoire comprend un transistor de lecture dont la première zone source-drain est reliée à la deuxième zone source-drain du transistor de mémorisation (S),
- dans lequel, à chaque fois, pour lire la première information et pour lire la deuxième information, on commande une électrode de grille du transistor de lecture.

9. Procédé selon la revendication 7 ou 8,
- dans lequel, à chaque fois, pour lire la première information et pour lire la deuxième information, on alimente l'électrode de grille du transistor de lecture avec une tension qui est égale à la somme de la tension de fonctionnement (V_{DD}) et de la tension de lecture.

10. Procédé selon l'une des revendications 7 à 9,
- dans lequel l'ensemble de cellules mémoires est disposé dans un substrat auquel est appliquée une tension qui, si le transistor de lecture est un transistor à canal n, n'est pas plus grande que la tension de lecture et qui, si le transistor de lecture est un transistor à canal p, n'est pas plus petite que la tension de lecture.
